**Europäisches Patentamt**

**European Patent Office**

**Office européen des brevets**

(19)

(11) Veröffentlichungsnummer: **0 176 909**
**B1**

(12) **EUROPÄISCHE PATENTSCHRIFT**

(45) Veröffentlichungstag der Patentschrift:
27.12.89

(51) Int. Cl.⁴: **H03K 19/086**

(21) Anmeldenummer: 85112021.2

(22) Anmeldetag: 23.09.85

(54) **UND-Gatter für ECL-Schaltungen.**

(30) Priorität: 24.09.84 DE 3435048

(43) Veröffentlichungstag der Anmeldung:
09.04.86 Patentblatt 86/15

(45) Bekanntmachung des Hinweises auf die Patenterteilung:
27.12.89 Patentblatt 89/52

(84) Benannte Vertragsstaaten:
AT DE FR GB IT NL

(56) Entgegenhaltungen:
EP-A- 0 035 326
US-A- 3 649 844
US-A- 4 394 657

PATENTS ABSTRACTS OF JAPAN, Band 6, Nr. 171, 4. September 1982, Seite P-140 1049, & JP - A - 57 88 593 (NIPPON DENSHIN DENWA KOSHA) 02.06.1982

(73) Patentinhaber: Siemens Aktiengesellschaft,
Wittelsbacherplatz 2, D-8000 München 2(DE)

(72) Erfinder: Wilhelm, Wilhelm, Dr., Geigenbergerstrasse 23,
D-8000 München 71(DE)
Erfinder: Schön, Karl-Reinhard, Dipl.-Ing.,
Stephansplatz 1, D-8000 München 2(DE)

**Beschreibung**

Die vorliegende Erfindung betrifft die Realisierung von UND-Verknüpfungen in Emitter-coupledlogic (ECL)-Schaltkreisen nach dem Oberbegriff des Patentanspruches 1.

ECL-Logikbausteine zeichnen sich durch besondere Schnelligkeit aus, weil keine Sättigung der Transistoren auftritt. Das Schaltungsprinzip beruht darauf, daß in einen Differenzverstärker ein konstanter Emitterstrom eingespeist wird und die Basis des ersten der Transistoren eine Vorspannung zwischen dem L- und H-Pegel besitzt. Je nach dem Potential der Basis des zweiten Transistors übernimmt dieser oder der erste Transistor den Strom, der am jeweils zugehörigen Kollektorwiderstand einen den Ausgangszustand bestimmenden Spannungsabfall hervorruft. UND-Verknüpfungen sind sehr einfach durch Seriesgating realisierbar, bei dem mehrere derartige Stufen übereinander liegen, d.h. die Kollektoren der untersten Pegelebene jeweils mit den Emittern der zur nächsthöheren Potentialebene gehörenden Differenzstufe verbunden sind und nur die oberste Ebene Kollektorwiderstände besitzt. Die Seriesgating-Schaltungstechnik wird u.a. in der US-A 3 649 844, Spalte 2, Zeile 53 ff. unter Nennung weiterer Literaturstellen beschrieben. Bei ODER-Gattern führen die Kollektoren der obersten Potentialebene zu einem Knotenpunkt und von dort zum Kollektorwiderstand.

Die Zahl der Eingangsvariablen bei UND-Verknüpfungen ist begrenzt durch die Anzahl der möglichen Seriesgating-Stufen, deren Pegel sich um je eine Diodenspannung unterscheiden. Um einen ausreichenden Signalhub zu gewährleisten, können unter Berücksichtigung der erforderlichen Stromquellen bei 4,5 bis 5,2 V-Versorgungsspannungen maximal drei Stufen übereinander liegen.

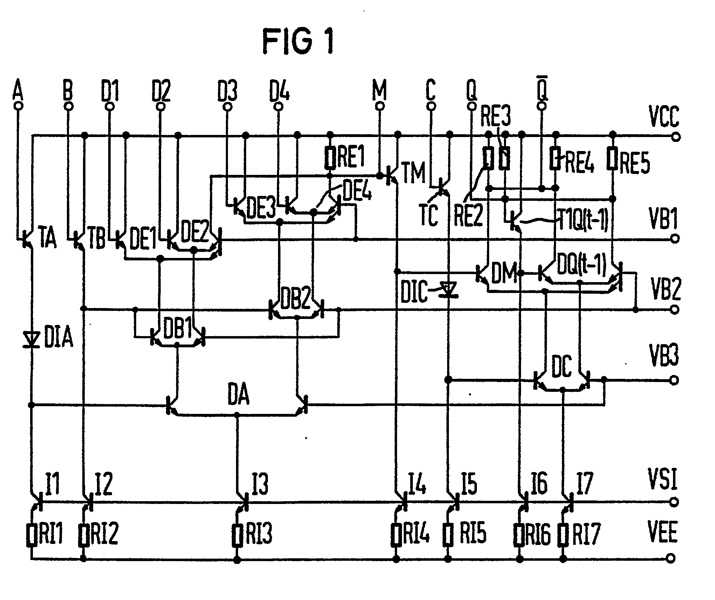

Die Realisierung von mehr als drei Eingangsvariablen in einem UND-Gatter erfolgt nach dem Stand der Technik durch Hintereinanderschalten mehrerer Seriesgating-Gatter, in denen jeweils Teilverknüpfungen durchgeführt werden. Dabei entsteht aus drei Eingangsvariablen ein (Hilfs-)-Ausgangssignal, das einen Eingang des nächstfolgenden Gatters ansteuert. Beispielsweise erfordern vier Eingangsvariable drei Seriesgating-Stufen des ersten und zwei Stufen des zweiten Gatters, wie in Fig. 1 am Beispiel einer Schaltung eines 4-Bit-Multiplexers mit Latch dargestellt wird.

Die zum Schaltungsbeispiel der Fig. 1 gehörende logische Funktion lautet:

$$Q(t) = A\,B\,\underline{C}\,D1 + A\,\overline{B}\,C\,D2 + \overline{A}\,B\,C\,D3 + \overline{A}\,\overline{B}\,C\,D4 + Q(t{-}1)\,\overline{C}.$$

Die maximal vier Eingangsvariablen der UND-Gatter erfordern zwei hintereinandergeschaltete Seriesgating-Gatter. Das erste Gatter realisiert die logischen Funktion

$$M = A\,B\,D1 + A\,\overline{B}\,D2 + \overline{B}B\,D3 + \overline{A}\,B\,D4$$

und das zweite Gatter die logische Funktion $Q(t) = M\,C + Q(t{-}1)\,\overline{C}$. Auf der untersten Pegelebene VSI befinden sich die die Schaltung versorgenden Konstantstromquellen I1 bis I7 mit ihren Emitterwiderständen RI1 bis RI7. Die beiden Differenzverstärker DA und DC der untersten Seriesgating-Stufe mit der Basisvorspannung VB3 werden von den Emitterfolgern TA und TC und deren Eingängen A und C gesteuert. Die Dioden DIA und DIC dienen zur Pegelanpassung an die nächsthöhere Stufe mit der Basisvorspannung VB2 für die Differenzstufen DB1, DB2, DM und DQ(t–1), die von den Emitterfolgern TB, TM und T1Q(t–1) mit den Eingängen B und M und, in Verbindung mit dem Basisvorwiderstand RE 3, von Q gesteuert werden. Dieser Ebene übergeordnet ist die dritte Seriesgating-Stufe mit den Differenzverstärkern DE1 bis DE4 und den Eingängen D1 bis D4. Die zugehörige Vorspannung VB1 liegt an den Basen zweier Zwei-Emitter-Transistoren, deren Kollektoren zusammengeführt sind und eine ODER-Verknüpfung in Verbindung mit dem gemeinsamen Kollektorwiderstand RE1 bilden. Ihr Kollektorpotential steuert über den Transistor TM den Eingang M des in Serie liegenden zweiten Seriesgating-Gatters, dessen Ausgangszustände Q und $\overline{Q}$ an den Kollektoren der Differenzstufen DM und DQ(t–1) und ihren Lastwiderständen RE2, RE4 und RE5 anstehen und den Ausgang der Schaltung bilden.

Nachteile dieser Methode sind die relativ langen Gatterlaufzeiten, die abhängig von der Zahl der zu durchlaufenden Seriesgating-Stufen sind und beispielsweise für die Schaltung nach Fig. 1 für das Signal Di nach Q 1,07 ns, für A nach Q 1,33 ns und für B nach Q 1,20 ns typisch betragen, der durch den hohen Schaltungsaufwand bedingte vergleichsweise hohe Leistungsbedarf und die vielfach nicht optimale Nutzung der Seriesgating-Stufen.

Der Erfindung liegt die Aufgabe zugrunde, durch schaltungstechnische Maßnahmen mit lediglich zwei Seriesgating-Stufen die Zahl der Eingangsvariablen noch zu erhöhen und die Signallaufzeit zu verkürzen.

Diese Aufgabe wird bei einer Anordnung der eingangs erwähnten Art erfindungsgemäß durch die Merkmale des Kennzeichens des Patentanspruchs 1 gelöst.

Ausgestaltungen des vorstehend definierten Erfindungsgedankens sind in den Unteransprüchen gekennzeichnet.

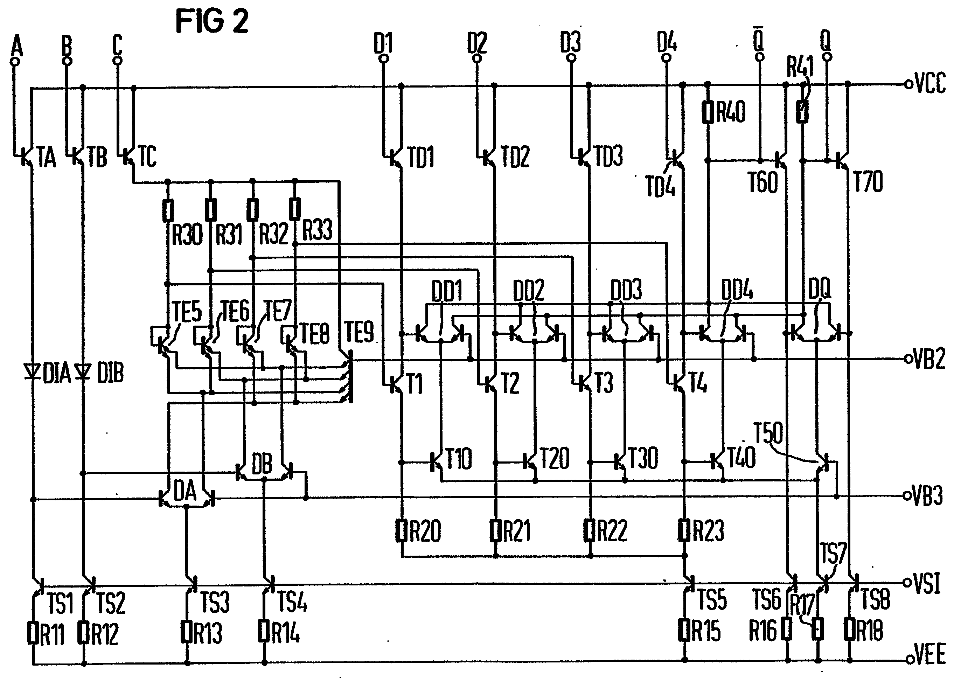

Die Erfindung wird im folgenden anhand eines in Fig. 2 als Zeichnung dargestellten Ausführungsbeispieles näher erläutert. Gleiche Elemente wie Fig. 1 sind dabei mit gleichen Bezugszeichen versehen.

Fig. 2 zeigt eine Schaltung derselben logischen Funktion wie in Fig. 1, wenn nur zwei Seriesgating-Stufen zur Verfügung stehen.

Das in Fig. 2 dargestellte Beispiel einer erfindungsgemäßen Schaltungsrealisation der gleichen logischen Funktion wie in Fig. 1 benötigt nur zwei Seriesgating-Stufen und ermöglicht einen höheren Signalhub und eine damit verbundene höhere Störsicherheit. Die Schaltung nach Fig. 2 führt eine zusätzliche UND-Verknüpfung zwischen den Signalen A und B durch und verwendet dazu einen aus der DE-PS 2 534 736 bekannten Dioden-Dekodierer. Das Ergebnis wird anschließend mit dem Signal C an einem Widerstand analog addiert.

Die Schaltung nach Fig. 2 wird von acht Stromquellen versorgt, die jeweils einen von der gemeinsamen Basisspannung VSI angesteuerten Transistor, TS1 bis TS8, und einen zugehörigen Emitterwiderstand, R11 bis R18, umfassen, dessen jeweils freien Anschluß am Pol VEE der Versorgungsspannungsquelle liegt.

Auf der nächsthöheren Pegelebene, der unteren Seriesgating-Stufe, befinden sich die beiden Differenzverstärker DA und DB, die die Basisvorspannung VB3 besitzen und von den über die zur Pegelanpassung dienenden Dioden DIA und DIB auf einem etwas höheren Potentialpegel angeordneten Eingangs-Emitterfolgern TA und TB mit deren Eingangssignalen A und B gesteuert werden. An den jeweils verbundenen Emittern von DA und DB liegen die Kollektoren der Stromquellentransistoren TS3 und TS4, an den Basen der nicht von VB3 vorgespannten Transistoren bzw. den Kathoden von DIA und DIB liegen die Kollektoren der Stromquellentransistoren TS1 und TS2.

Auf der gleichen Pegelebene liegen die Stromschaltertransistoren T10 bis T50, deren Emitter sämtlich miteinander und mit dem Kollektor von TS7 verbunden sind. Die Basen der Steuertransistoren T10 bis T40, die die Verknüpfung der Adressiersignale A, B und C mit den Datensignalen D1 bis D4 bewirken, liegen über die zugeordneten potentialbestimmenden Widerständen R20 bis R23 am Kollektor des Stromquellentransistors TS5 und werden von den auf der mittleren Pegelebene angeordneten Emitterfolgern T1 bis T4 angesteuert. Der von der Seriesgating-Spannung VB3 vorgespannte Referenztransistor T50 ist für das inverse Steuersignal C̄ des Latch verantwortlich.

Auf der nächsthöheren Pegelebene, die gleichzeitig die obere Seriesgating-Stufe bildet, wird die Verknüpfung der Eingangssignale A, B und C durchgeführt. Die UND-Beziehungen zwischen den Signalen A und B und ihren Komplementärsignalen erfolgt mit Hilfe eines Dioden-Dekodierers. Dieser enthält die als Dioden geschalteten Zweiemittertransistoren TE5 bis TE8 und den Vieremittertransistor TE9, an dessen Basis die Vorspannung VB2 liegt.

Der erste Emitter von TE9 ist mit je einem Emitter von TE5 und TE7 sowie dem Kollektor des von VB3 vorgespannten Transistoren der Stufe DB verbunden, der zweite Emitter von TE9 mit je einem Emitter von TE6 und TE8 sowie dem Kollektor des vom Signal B angesteuerten Transistors der Differenzstufe DB, der dritte Emitter von TE9 mit je dem zweiten Emitter von TE5 und TE6 sowie dem Kollektor des von VB3 vorgespannten Transistors der Differenzstufe DA und schließlich sind die verbleibenden Emitter des Dekodierers, d.h. der vierte Emitter von TE9 und je der zweite Emitter von TE7 und TE8, und der Kollektor des vom Signal A angesteuerten Transistors der Stufe DA zusammengeführt.

Die Ausgänge des Dioden-Dekodierers, d.h. die Kollektoren der Zweiemittertransistoren TE5 bis TE8 steuern die Basen der Emitterfolger-Transistoren T1 bis T4 an und liegen über die Widerstände R30 bis R33 am Ausgang des vom Signal C angesteuerten Emitterfolgers TC. Der Emitter von TC ist außerdem direkt mit dem Kollektor des Vieremittertransistors TE9 verschaltet. Ähnlich wie in der Schaltung nach Fig. 1 bestimmt auch in Fig. 2 das Signal C den Spannungspegel der Ausgänge des Dioden-Dekodierers, wobei die Signalpegel eine Sättigung der Transistoren T1 bis T4 ausschließen.

Die Kollektoren von T1 bis T4 sind an die Ausgänge der von den Eingangssignalen D1 bis D4 gesteuerten Emitterfolger TD1 bis TD4 und an die Basen je eines der Steuertransistoren der Differenzverstärkerstufen DD1 bis DD4 angeschlossen. An der Basis des je anderen Transistors von DD1 bis DD4 liegt die Seriesgating-Spannung VB2, während die je Differenzstufe zusammengefaßten Emitter mit den Kollektoren von T10 bis T40 verbunden sind.

Die Kollektoren der von VB2 vorgespannten Transistoren der Differenzverstärker DD1 bis DD4 sind mit dem Kollektor des ersten Transistors eines weiteren Differenzverstärkers DQ zusammengelegt und über den Widerstand R41 mit den Pol VCC der Versorgungsspannungsquelle verbunden. An den Kollektoren läßt sich das Ausgangssignal Q abgreifen, das auch den Emitterfolger T70 ansteuert, der vom Kollektor des Transistors TS8 mit Strom versorgt wird und dessen Ausgang den zweiten Transistor der weiteren Differenzstufe DQ steuert. Der Kollektor dieses zweiten Transistors der Differenzstufe DQ besitzt mit den Kollektoren der nicht von VB2 vorgespannten Steuertransistoren der Differenzverstärker DD1 bis DD4 einen gemeinsamen Knotenpunkt, der über den Widerstand R40 an den Pol VCC der Versorgungsspannungsquelle führt. Am so definierten Knotenpunkt ist das Ausgangssignal Q̄ abzugreifen, das den Emitterfolger T60 steuert, der vom Kollektor von TS6 mit Strom versorgt wird und dessen Ausgang den ersten Transistor der weiteren Differenzver-stärkers DQ ansteuert. Die gemeinsamen Emitter der Differenzstufe DQ sind mit dem Kollektor des Transistors T50 verbunden. Die Kollektoren der Emitterfolger TA, TB, TC, TD1 bis TD4, T60 und T70 liegen direkt am Pol VCC der Versorgungsspannungsquelle.

Die erfindungsgemäße Schaltung nach Fig. 2 erzielt gegenüber der die gleiche logische Funktion realisierenden Schaltung mit zwei seriellen Seriesgating-Gattern nach Fig. 1 für die Verzögerung von D$_i$ nach Q um ca. 55%, von A nach Q um ca. 20% und von B nach Q um ca. 10% geringere Laufzeiten.

**Patentansprüche**

1. Halbleiterschaltungsanordnung in ECL-Technik zur Realisation logischer Konjunktionen zwischen mehr als zwei Eingangsvariablen mit zwei Seriesgating-Stufen, bei denen von je einer Eingangsvariablen gesteuerte, je einen Referenz- und mindestens einen Steuerkreis enthaltende ECL-Stromschalter in durch mindestens eine Dioden-schwellspannung voneinander getrennten Span-nungspegelstufen hintereinander geschaltet logi-sche Konjunktionen ergeben, dadurch gekennzeich-net, daß im Steuerkreis eines ECL-Stromschalters mit einem den Referenzkreis bildenden Mehremittertransistor (TE9) ein als Diode geschalteter Transistor mit mindestens zwei Emittern (TE5 bis TE8) und einem Kollektorwiderstand (R30 bis R33) enthalten ist, der eine logische Konjunktion der an den Emittern des als Diode geschalteten Transistors (TE5 bis TE8) anliegenden Signale realisiert.

2. Halbleiterschaltungsanordnung nach Anspruch 1, dadurch gekennzeichnet, daß die Eingangsvariablen (A, B, C, D1 bis D4) Adressiersignale (A, B, C) und/oder Datensignale (D1 bis D4) und ihrer Komplementärsignale sind.

3. Halbleiterschaltungsanordnung nach einem der Ansprüche 1 bis 2, dadurch gekennzeichnet, daß Eingangsvariable (A, B, C) Steuerkreise von Seriesgating-Stufen über Emitterfolger (TA, TB, TC) ansteuern.

4. Halbleiterschaltungsanordnung nach einem der Ansprüche 1 bis 3, dadurch gekennzeichnet, daß eine Seriesgating-Stufe mindestens zwei von je einer Eingangsvariablen (A, B, C) gesteuerte ECL-Stromschalter (DA, DB) enthält.

5. Halbleiterschaltungsanordnung nach einem der Ansprüche 1 bis 4, dadurch gekennzeichnet, daß jeweils durch Widerstände (R30, R31, R32, R33), deren eine Anschlußklemme an hohes Potential schaltbar ist und deren andere Anschlußklemme jeweils mit einer Schaltdiode (TE5, TE6, TE7, TE8) verbunden ist und/oder durch Widerstände (R20...23), die zwischen einem niedrigen Potential (VB3) und einer gegen das noch niedrigere Bezugspotential (VEE) geschalteten Stromquelle (TS5, R15) angeordnet sind, logische Konjunktionen zwischen Adressiersignalen (A, B, C) und/oder Datensignalen (D1 bis D4) und/oder von diesen abhängigen Signalen und/oder Ausgangssignalen einer Spannungspegelstufe (VB2, VB3) realisiert sind.

6. Halbleiterschaltungsanordnung nach einem der Ansprüche 1 bis 5, dadurch gekennzeichnet, daß eine logische Konjunktion zwischen Eingangsvariablen (A, B, C, D1 bis D4) und/oder von diesen abhängigen Signalen durch Serienschaltung der Ausgangskreise zweier von den Eingangsvariablen mittelbar oder unmittelbar gesteuerter Transistoren (T1 bis T4, TD1, TD4) mit an deren Verbindungspunkt angeschlossener Basis eines Steuertransistors eines ECL-Stromschalters (DD1 bis DD4) und eine zwischen die gekoppelten Emitter des ECL-Stromschalters (DD1 bis DD4) und den freien, nicht mit der Basis des ECL-Stromschalters (DD1 bis DD4) verbundenen Emitter des von einer Eingangsvariablen mittelbar oder unmittelbar gesteuerten Transistors (T1 bis T4) geschaltete Kollektor-Basis-Strecke eines zu einem anderen ECL-Stromschalter (T10 bis T40, T50) gehörenden Steuerkreises (T10 bis T40) realisiert wird.

7. Halbleiterschaltungsanordnung nach einem der Ansprüche 1 bis 6, dadurch gekennzeichnet, daß einer der mittelbar oder unmittelbar gesteuerten Transistoren (T1 bis T4) von einem aus dem Ausgangssignal einer Seriesgating-Stufe und einem von einer Eingangsvariablen (C) abhängigen Signal durch Spannungsaddition an einem Widerstand (R30 bis R33) gebildeten Signal angesteuert wird.

## Claims

1. Semiconductor circuit arrangement in ECL technology for implementing logic combinations between more than two input variables with two series gating stages in which series-connected ECL current switches, which are controlled by one input variable in each case and include, in each case, one reference circuit and at least one control circuit, yield logic combinations in voltage level stages separated from one another by at least one diode threshold voltage, characterized in that there is contained in the control circuit of an ECL current switch with a multiple-emitter transistor (TE9) forming the reference circuit a transistor with at least two emitters (TE5 to TE8) and a collector resistor (R30 to R33), which is connected as a diode and implements a logic combination of the signals present at the emitters of the transistor (TE5 to TE8) connected as a diode.

2. Semiconductor circuit arrangement according to Claim 1, characterized in that the input variables (A, B, C, D1 to D4) are addressing signals (A, B, C) and/or data signals (D1 to D4) and their complementary signals.

3. Semiconductor circuit arrangement according to one of Claims 1 to 2, characterized in that input variables (A, B, C) activate control circuits of series gating stages via emitter followers (TA, TB, TC).

4. Semiconductor circuit arrangement according to one of Claims 1 to 3, characterized in that a series gating stage includes at least tow ECL current switches (DA, DB) controlled in each case by one input variable (A, B, C).

5. Semiconductor circuit arrangement according to one of Claims 1 to 4, characterized in that logic combinations between addressing signals (A, B, C) and/or data signals (D1 to D4) and/or signals dependant thereon and/or output signals of a voltage level stage (VB2, VB3) are implemented in each case by resistors (R30, R31, R32, R33), of which one terminal can be connected to a high potential and of which the other terminal is connected in each case to a switching diode (TE5, TE6, TE7, TE8), and/or by resistors (R20...23) which are arranged between a lower potential (VB3) and a current source (TS5, R15) connected against the even lower reference potential (VEE).

6. Semiconductor circuit arrangement according to one of Claims 1 to 5, characterized in that a logic combination is implemented between input variables (A, B, C, D1 to D4) and/or signals dependant thereon via a series connection of the output circuits of two transistors (T1 to T4, TD1, TD4), which are indirectly or directly controlled by the input variables and have connected at their connection point the base of a control transistor of an ECL current switch (DD1 to DD4), and via a collector-base section of a control circuit (T10 to T40) belonging to another ECL current switch (T10 to T40, T50), which section is connected between the coupled emitters of the ECL current switch (DD1 to DD4) and the free emitter, not connected to the base of the ECL current switch (DD1 to DD4) of the transistor (T1 to T4) indirectly or directly controlled by an input variable.

7. Semiconductor circuit arrangement according to one of Claims 1 to 6, characterized in that one of the indirectly or directly controlled transistors (T1 to T4) is activated by a signal formed by voltage addition at a resistor (R30 to R33) from the output signal from a series gating stage and a signal dependent upon an input variable (C).

## Revendications

1. Montage à semiconducteurs réalisé selon la technique ECL pour réaliser des conjonctions logiques entre plus de deux variables d'entrée, comportant des étages de transfert série, dans lesquels des interrupteurs de courant ECL, commandés chacun par une variable d'entrée et contenant chacun un circuit de référence et au moins un circuit de commande, réalisent des conjonctions logiques établies en série dans des étages délivrant des niveaux de tension, séparés les uns des autres par au moins une tension de seuil d'une diode, caractérisé par le fait que le circuit de commande d'un interrupteur de courant ECL comportant un transistor à émetteurs multiples (TE9), formant le circuit de référence, contient un transistor, branché en tant que diode, avec au moins deux émetteurs (TE5 à TE8) et une résistance de collecteur (R30 à R33) et réalise une conjonction logique des signaux appliqués aux émetteurs du transistor (TE5 à TE8) branché en tant que diode.

2. Montage suivant la revendication 1, caractérisé par le fait que les variables d'entrée (A, B, C, D, D1 à D4) sont des signaux d'adressage (A, B, C) et/ou des signaux de données (D1 à D4) et leurs signaux complémentaires.

3. Montage à semiconducteurs suivant l'une des revendications 1 à 2, caractérisé par le fait que des variables d'entrée (A, B, C) commandent des circuits de commande d'étages de transfert série, par l'intermédiaire d'émetteurs-suiveurs (TA, TB, TC).

4. Montage à semiconducteurs suivant l'une des revendications 1 à 3, caractérisé par le fait qu'un étage de transfert série contient au moins deux interrupteurs de courant ECL (DA, DB), commandés par une variable d'entrée respective (A, B, C).

5. Montage à semiconducteurs suivant l'une des revendications 1 à 4, caractérisé par le fait que des conjonctions logiques entre des signaux d'adressage (A, B, C) et/ou des signaux de données (D1 à D4) et/ou des signaux dépendant des signaux précédents et/ou des signaux de sortie d'un étage (VB2, VB3) délivrant le niveau de tension sont réalisés respectivement par l'intermédiaire de résistances (R30, R31, R32, R33), dont une borne de raccordement peut être portée à un potentiel élevé et dont l'autre borne de raccordement est reliée respectivement à une diode de commutation (TE5, TE6, TE7, TE8) et/ou au moyen de résistances (R20 ... 23), qui sont branchées entre un potentiel bas (VB3) et une source de courant (TS5, R15) raccordée au potentiel de référence encore plus bas (VEE).

6. Montage à semiconducteurs suivant l'une des revendications 1 à 5, caractérisé par le fait qu'une conjonction logique entre des variables d'entrée (A, B, C, D1 à D4) et/ou des signaux dépendant de ces variables est réalisée au moyen du raccordement en série des circuits de sortie de deux transistors (T1 à T4, TD1, TD4), commandés directement ou indirectement par les variables d'entrée, à la base, raccordée au point de jonction de ces transistors, d'un transistor de commande d'un interrupteur de courant ECL (DD1 à DD4) et au moyen d'une voie collecteur-base, branchée entre les émetteurs accouplés de l'interrupteur de courant ECL (DD1 à DD4) et l'émetteur libre, non relié à la base de l'interrupteur de courant ECL (DD1 à DD4), d'un transistor (T1 à T4) commandé directement ou indirectement par une variable d'entrée, d'un circuit de commande (T10 à T40) associé à un autre interrupteur de courant ECL (T10 à T40, T50).

7. Montage à semiconducteur suivant l'une des revendications 1 à 6, caractérisé par le fait que l'un des transistors (T1 à T4), commandé directement ou indirectement, est commandé par un signal formé à partir du signal de sortie d'un étage de transfert série et à partir d'un signal, qui dépend d'une variable d'entrée (C), par addition de tension au niveau d'une résistance (R30 à R33).

# FIG 1

FIG 2

EP 0 176 909 B1